Europäisches Patentamt

European Patent Office

Office européen des brevets

(11) Numéro de publication: **0 504 532 A1**

# DEMANDE DE BREVET EUROPEEN

(21) Numéro de dépôt: **91420097.7**

(51) Int. Cl.5: **H01L 23/373**

(22) Date de dépôt: **22.03.91**

(43) Date de publication de la demande:
**23.09.92 Bulletin 92/39**

(84) Etats contractants désignés:
**AT BE CH DE ES FR GB IT LI LU NL SE**

(71) Demandeur: **PECHINEY RECHERCHE (Groupement d'Intérêt Economique géré par l'ordonnance du 23 Septembre 1967) 10, place des Vosges Immeuble Balzac La Défense 5 F-92400 Courbevoie(FR)**

(72) Inventeur: **Dermarkar, Salim**

La Commanderie
**F-38430 Saint Jean De Moirans(FR)**
Inventeur: **Dumant, Xavier**
**7330 rue de Chambois**
**Montreal, Ouebec H3R 3E5(CA)**
Inventeur: **Lebailly, Michel**
**Chemin J.M. Calvier, Les Charagons**
**F-84500 Bollene(FR)**

(74) Mandataire: **Vanlaer, Marcel et al**
**PECHINEY 28, rue de Bonnel**
**F-69433 Lyon Cédex 3(FR)**

(54) **Matériau pour composants électroniques passifs.**

(57) L'invention concerne un matériau pour composants électroniques passifs ayant une conductivité thermique élevée, une masse volumique et un coefficient de dilatation faibles.

Il est caractérisé en ce qu'il est constitué par un composite isotrope formé d'un métal appartenant au groupe composé de l'aluminium pur, du magnésium pur et de leurs alliages et d'une céramique appartenant au groupe composé du carbure de silicium, du graphite et de leurs variantes, ces éléments étant sélectionnés de façon précise en structure et en proportions relatives.

Ce matériau trouve son application notamment en électronique pour la réalisation de fonds dissipateurs, de supports, de drains thermiques et de boîtiers d'encapsulation de circuits hybrides de micro-électronique de puissance.

FIG.4

L'invention concerne un matériau pour composants électroniques passifs ayant une conductivité thermique élevée, une masse volumique faible, une dilatabilité faible.

Il faut entendre ici par composants électroniques passifs, ceux qui ne participent pas directement à l'activité électronique. Cette invention concerne plus particulièrement les matériaux destinés à réaliser des structures telles que fonds dissipateurs, des supports et des pièces polaires de circuits de puissance, des supports de diodes laser, des drains thermiques et des boîtiers d'encapsulation de circuits hybrides de micro-électronique de puissance ou de circuits hyperfréquence. Le terme électronique inclut également ce qui est en rapport avec l'optoélectronique.

Il est connu que dans lesdits composants, ces matériaux sont généralement associés à des substrats isolants en céramique tels que l'alumine par exemple ou à des semi-conducteurs tels que le silicium ou l'arséniure de gallium.

Quand ces composants comportent des éléments de puissance, leur fonctionnement conduit à un dégagement de chaleur important. Il est donc nécessaire pour ne pas les détériorer par un échauffement exagéré de dissiper les calories émises le plus rapidement possible. Pour cela, on met en oeuvre un matériau de conductivité thermique la plus élevée possible.

Malgré tout, il se produit une élévation de température, et si le coefficient de dilatation a du matériau est trop différent de celui du substrat en alumine, il se développe dans ce dernier des contraintes supérieures à la résistance de la céramique d'où des ruptures qui nuisent à la conductivité de l'ensemble et à son isolement électrique. C'est pourquoi, il faut également que le matériau ait un coefficient compatible avec celui de l'alumine et de préférence inférieur à 16 p.p.m./K dans l'intervalle de température 30-400°C.

Par ailleurs l'utilisation éventuelle de ces circuits dans des véhicules mus par une source d'énergie conduit à rechercher des matériaux ayant une masse volumique la plus faible possible et de préférence inférieure à 3100 kg.m$^{-3}$ afin de réduire le plus possible la consommation d'énergie nécessaire à leur propulsion.

En outre, comme les circuits sont sensibles à l'environnement, on souhaite que le matériau présente un caractère amagnétique convenable ainsi qu'une bonne étanchéité au milieu extérieur.

La réalisation d'un matériau présentant, un compromis entre toutes ces propriétés a fait l'objet de nombreuses recherches qui ont abouti à des solutions plus ou moins intéressantes.

Ainsi, on s'est tourné vers des matériaux comme l'acier, le beryllium, certains alliages d'aluminium en raison de leur bonne conductivité ; mais la valeur relativement importante de leur module d'élasticité et de leur dilatabilité nécessite le recours à des joints ou a des adhésifs capables d'accommoder la différence de dilatabilité de l'alumine et cela conduit à une réduction de conductivité thermique de l'ensemble.

On s'est alors orienté vers des matériaux présentant une faible dilatabilité comme le kovar (alliage de fer-nickel-cobalt) ou le molybdène ou encore des matériaux multi-métaux du type cuivre/invar/cuivre et également le titane et ses alliages. Mais, à part le molybdène, tous ces matériaux sont fortement pénalisés par une faible conductivité notamment dans le sens perpendiculaire au plan du substrat. Tous ont également une masse volumique élevée dont la plus faible, celle du titane, est de l'ordre de 4500 kg/m$^3$ . Par ailleurs, le molybdène est cher et difficile à mettre en oeuvre à cause de sa mauvaise résistance à l'oxydation : quant au kovar, son usinage est délicat car il se tord sous l'effet de contraintes internes et de nombreux recuits sont nécessaires si on veut le travailler correctement.

C'est pourquoi la demanderesse, consciente que les matériaux utilisés jusqu'à présent possédaient des lacunes, a cherché à mettre au point un nouveau matériau qui réalise le compromis de propriétés suivant :

- coefficient de dilatation α faible et en tout cas compatible avec celui d'une céramique comme l'alumine, le silicium ou l'arséniure de gallium, lors d'une variation de température, pouvant aller jusqu'à 400°C ;
- conductibilité thermique la plus élevée possible ;
- masse volumique aussi petite que possible ;
- étanchéité à l'environnement ;
- bonne résistance à la corrosion
- usinabilité convenable ;
- aptitude au nickelage ;
- possibilité de soudage ;
- caractère amagnétique.

Ses recherches ont abouti à un matériau isotrope pour composants électroniques passifs c'est-à-dire présentant dans toutes les directions un coefficient de dilatation α moyen entre 30°C et 250°C compris entre 2 p.p.m./K et 13 p.p.m./K, une masse volumique inférieure à 3100 kg/m$^3$ et une conductivité thermique λ supérieure à 100 W/m/K dans lequel la structure est composite et qui est formé d'une part par un métal appartenant au groupe constitué par l'aluminium et ses alliages, le magnésium et ses alliages et d'autre part par une céramique appartenent au groupe constitué par des particules de carbure de silicium vert, du graphite polygranulaire, ladite céramique étant utilisée en proportion volumique comprise entre 50 et 90%.

De préférence, pour avoir une conductivité très élevée c'est-à-dire supérieure à 150 W/m/K, un coefficient de dilatation compris entre 7 et 13 p.p.m./K, un module d'Young supérieur à 120 GPa, on utilise les particules de carbure de silicium vert en proportion comprise entre 50 et 75%.

Si on veut avoir un coefficient de dilatation plus faible compris entre 4 et 10 p.p.m./K, une densité plus faible et inférieure à 2300 kg/m$^3$, un module d'Young inférieur à 50 GPa, tout en gardant une conductivité thermique supérieure à 100 W/m/K, on utilise du graphite polygranulaire en proportion volumique comprise entre 65 et 90%.

Ainsi, le matériau selon l'invention diffère des précédents en ce qu'il n'est plus uniquement constitué par un ou plusieurs métaux disposés en sandwich, mais par des mélanges polyphasés de métal et de céramique ayant une structure isotrope.

Le métal peut être de l'aluminium pur, du magnésium pur ou leurs alliages. En effet, ces métaux combinent une bonne conductivité, une faible densité et un bas point de fusion.

Les alliages sont choisis en fonction de leur conductivité sachant que la valeur de cette propriété décroît en fonction de la nature et de la quantité des éléments d'addition et qu'elle décroît plus quand lesdits éléments sont en solution solide que lorsqu'ils sont présents sous forme de précipités.

Dans le cas des alliages d'aluminium, on utilise ceux qui sont peu chargés en éléments d'addition : le zinc, le cuivre, le magnésium, le fer et le nickel peuvent être tolérés en faible quantité ; quant au manganèse, au titane, au vanadium et au lithium, ils sont à éviter.

De préférence, on choisit les alliages des séries 1000, 5000 et 6000 suivant les normes de l'Aluminum Association, ainsi que des alliages de moulage et plus particulièrement parmi ces derniers, ceux renfermant 7, 10 et 13% de silicium, tels les alliages A356, A357 et A413.2 et parmi ceux de la série 6000, les alliages 6061 et 6101 suivant les normes de l'Aluminum Association.

Le matériau selon l'invention est constitué également par des éléments céramiques sous forme de particules équiaxes ou d'amas polygranulaires poreux.

Tous les éléments céramiques n'ont pas la même efficacité et on recourt, de préférence, à ceux qui ont une faible dilatabilité, une conductivité thermique élevée et une masse volumique faible.

Plus spécifiquement, on utilise du carbure de silicium ou du graphite polygranulaire qui présentent un excellent compromis de propriétés.

En ce qui concerne les particules de carbure de silicium (SiC), elles ont une taille comprise entre 0,5 et 400 $\mu$m et plus spécifiquement entre 3 et 50 $\mu$m.

Pour que le composite obtenu ait une conductivité thermique élevée, il faut nécessairement que les particules de SiC aient une pureté élevée et une teneur en SiC supérieure à 99% en masse. L'appellation usuelle de cette catégorie de SiC est "SiC vert" qui suivant "GMELIN Handbook of Inorganic Chemistry" 8ème édition, Supplément Vol.B3, p.60, Ed.Springer Verlag, 1986, a la composition suivante :

|  | % en poids |
|---|---|
| SiC | 99,00 à 99,4 |
| C libre | 0,05 à 0,10 |
| SiO$_2$ | 0,40 à 0,60 |
| Fe$_2$O$_3$ | 0,10 à 0,20 |
| Al$_2$O$_3$ | 0,05 à 0,10 |

et auquel on peut comparer le "SiC noir" habituellement utilisé dans l'art antérieur et dont la composition est la suivante :

|  | % en poids |
|---|---|
| SiC | 98,75 à 99,2 |
| C libre | 0,10 à 0,15 |
| SiO$_2$ | 0,50 à 0,70 |
| Fe$_2$O$_3$ | 0,10 à 0,20 |
| Al$_2$O$_3$ | 0,25 à 0,35 |

En ce qui concerne le graphite, on utilise des amas polygranulaires poreux dont la taille est inférieure à

20 $\mu$m. Le grain du graphite a une forme équiaxe et l'amas de graphite ne présente aucune direction privilégiée afin de conserver au produit son caractère isotrope. Ceci exclut en particulier toutes les fibres de graphite.

La céramique peut être utilisée sous diverses formes appelées préformes poreuses :

- soit sous forme de particules agglomérées, notamment dans le cas du carbure de silicium,
- soit sous forme d'amas polygranulaires, dans le cas du graphite.

Dans la présente invention, la demanderesse a retenu les préformes poreuses dans lesquelles la fraction volumique de phase céramique est supérieure à 50% et inférieure à 90%.

En effet, une fraction volumique inférieure à 50% conduirait à un coefficient de dilatation du composite trop élevé et supérieur à 13 p.p.m./K, tandis qu'une fraction volumique supérieure à 90% poserait des problèmes techniques de fabrication.

Ensuite, cette préforme est infiltrée par le métal liquide suivant des techniques connues de l'homme de l'art (voir par exemple A.G.KELLY et G.I. DAVIES, Metallurgical Reviews, 1965 Vol.10 n°37), qui peuvent nécessiter l'utilisation d'une pression appliquée et/ou d'un préchauffage ; mais toute autre technique d'imprégnation ou de moulage connue peut être mise en oeuvre (voir les brevets US 4376804 et US 4777998, EP 0105890 et EP 045510 par exemple).

Dans le cas de métal constitué par un alliage de la série 6000 et des alliages AA 356 et AA 357 et tout alliage pouvant donner lieu à durcissement structural, on fait subir au matériau après moulage, un traitement thermique du type recuit ou revenu pour améliorer ses propriétés mécaniques.

Le matériau composite ainsi obtenu pourra nécessiter des opérations complémentaires d'usinage et de traitement de surface (nickelage, argenture ou dorure) bien connues de l'homme de l'art.

Ce matériau est alors apte à assurer aux composants actifs et/ou passifs qui lui sont associés des fonctions de liaison (dans le cas d'un support), des fonctions de liaison et de dissipation thermique (dans le cas d'un drain thermique), des fonctions de liaison, de dissipation thermique et d'interconnexion (dans le cas d'un boîtier d'encapsulation) ou des fonctions de liaison, de dissipation thermique, d'interconnexion et de protection contre l'environnement (dans le cas d'un boîtier d'encapsulation hermétique).

Dans le cas particulier où on veut réaliser un boîtier d'encapsulation hermétique, on forme d'abord un boîtier, à l'intérieur duquel sont logés les éléments semi-conducteurs ou les isolants et les circuits actifs, que l'on ferme avec un couvercle qui est fixé par exemple par soudobrasage au laser.

Enfin, la réalisation de structures du type drain thermique ou support s'accompagne éventuellement d'une protection par un vernis ou une résine.

L'invention sera mieux comprise à l'aide des figures jointes :

- Figure 1 : une vue en coupe verticale d'un composant électronique comprenant une structure en forme de drain thermique pour circuit de puissance.
- Figure 2 : une vue de dessus du composant de la figure 1.
- Figure 3 : une vue en coupe verticale d'un composant électronique comprenant une structure en forme de boîtier d'encapsulation avec ses connexions et son couvercle.
- Figure 4 : une vue de dessus du composant de la figure 3, couvercle enlevé.

Plus précisément, on distingue :

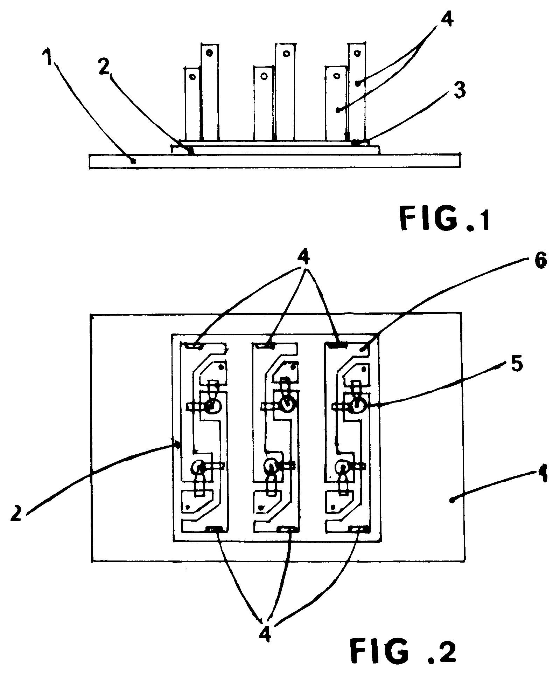

- sur la figure 1, un drain thermique 1 réalisé en matériau selon l'invention, sur lequel repose un isolant 2 formé par une couche d'alumine sur lequel est placé un circuit actif 3 relié à l'environnement par les connexions 4 d'entrée/sortie.
- sur la figure 2, le drain thermique 1, son isolant 2, son circuit actif 3 formé de thyristors 5, des pistes conductrices 6 et leurs connexions 4.

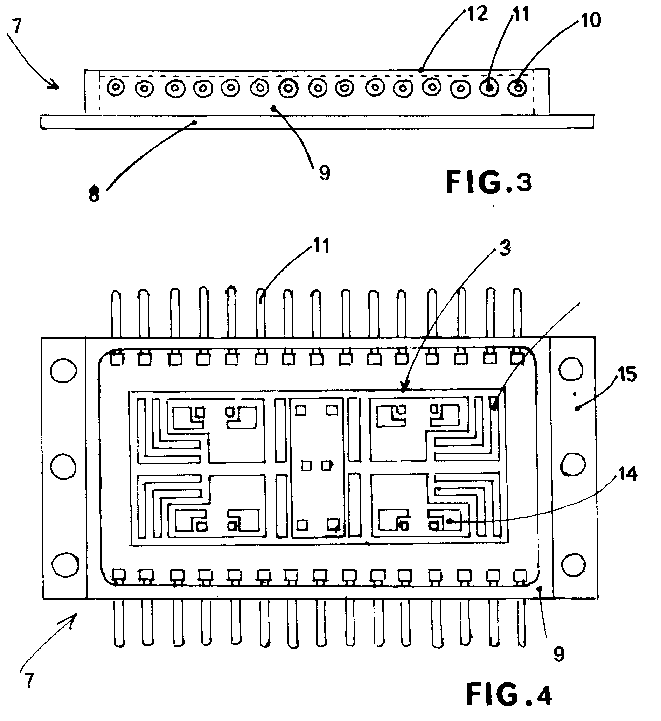

- sur la figure 3, un boîtier 7 réalisé en matériau selon l'invention, formé d'une semelle 8 sur laquelle repose un cadre 9 munie d'ouvertures 10 à travers lesquelles passent les connexions 11 des circuits actifs. A l'intérieur du cadre et à sa partie supérieure est fixé un couvercle 12.
- sur la figure 4, un boîtier 7 avec sa semelle 8, son cadre 9, ses connexions 11. Sur la semelle repose un isolant 13 sur lequel sont placés des circuits actifs 14 comprenant des pistes conductrices 15. Les liaisons entre connexions et circuits actifs n'ont pas été représentées.

Afin d'assurer, la stabilité dimensionnelle et l'intégrité des interconnexions de tels assemblages lorsqu'ils sont soumis au cyclage thermique, il est essentiel que le matériau composite ait le même comportement en dilatation dans toutes les directions. Seuls les matériaux composites isotropes ont donc été retenus dans le cadre de la présente invention.

L'invention peut être illustrée à l'aide des exemples suivants.


EXEMPLE 1 :

on a réalisé des matériaux composites formés d'un métal choisi parmi les alliages AA1050 et A357 et d'une céramique sous forme de particules de SiC noir de pureté inférieure à 99% et possédant des impuretés de réseau importantes, d'autre part de SiC vert de pureté supérieure à 99% et possédant des impuretés de réseau faibles de la manière suivante :

une préforme de 120 mm de diamètre a été obtenue par filtration d'une suspension de particules de SiC de taille moyenne 44,5 $\mu$ m contenant de la silice colloïdale pour assurer sa cohésion. Après séchage, elle contenait en volume 55% de particules et 5,5% de silice. Cette préforme a été infiltrée par la technique de fonderie de moulage de cire perdue.

Après solidification et démoulage, on a obtenu un matériau composite de masse volumique de 2975 kg/m$^3$ correspondant à la valeur théorique. Le coefficient de dilatation moyen est de 10,5 p.p.m./K entre 30°C et 250°C. Ce coefficient est identique dans toutes les directions. Le module d'Young est de 125 GPa et la résistance en flexion de 307 MPa. La résistivité électrique est de 11 microhm-cm. La conductivité thermique de ce matériau composite a été calculée à partir de mesures par la méthode flash de la diffusivité thermique et de la chaleur volumique ; les valeurs expérimentales (en W/m/k) sont reportées au tableau suivant en fonction du type de particules et de la nature de l'alliage :

| | | conductivité thermique (W/m/K) | |
| --- | --- | --- | --- |
| | | SiC noir | SiC vert |
| ALLIAGE | AA1070 | 122 | 170 |
| | A357 | 113 | 171 |

On constate que la pureté des particules de SiC a une incidence beaucoup plus grande que le choix de l'alliage sur la conductivité thermique du matériau composite. Il est donc nécessaire de sélectionner des particules de SiC à teneur en impuretés de réseau contrôlée, et à teneur en SiC >99% en masse (SiC vert) pour avoir une conductivité supérieure à 150 W/m/K.

EXEMPLE 2 :

on a réalisé un matériau composite contenant l'alliage AA1090 et 18% en volume de fibres de carbone ex.P.A.N. (polyacrylonitrile) graphitées à 2600°C ayant une masse volumique voisine de 2500 kg/m$^3$, une conductivité dans le sens perpendiculaire au plan des fibres de 164 W/m/K, un coefficient de dilatation tangent à 30°C de l'ordre de 19 p.p.m./K entre 30 et 250°C, de l'ordre de 6,4 p.p.m./K et entre 30 et 400°C de l'ordre de 3 p.p.m./K pour des mesures effectuées dans le plan. Par contre, le coefficient de dilatation entre 30 et 250°C est de 55,5 p.p.m./K lorsqu'il est mesuré dans la direction normale au plan.

Cet exemple montre qu'il n'est pas bon d'utiliser la phase céramique sous forme de fibres car ceci introduit une anisotropie des caractéristiques de dilatation très importante.

En effet, dans ce cas, on a presque un facteur 10 entre le coefficient de dilatation dans le plan et le coefficient de dilatation normal au plan.

EXEMPLE 3 :

on a réalisé des matériaux composites comprenant un graphite polygranulaire (référence S2457 du Carbone Lorraine) et différents alliages d'aluminium et de magnésium. Il s'agit d'aluminium de pureté supérieure à 99,7% (AA1070), d'aluminium contenant 5% de magnésium (AG5), d'aluminium contenant 5% de nickel (AN5), d'aluminium contenant 7% de silicium et 0,6% de magnésium (AS7G0,6), de magnésium contenant 5% de zinc et 1% environ de terres rares (RZ5).

Après solidification et démoulage, on a obtenu des matériaux composites dont les propriétés de dilatation, de conductivité thermique, de densité et parfois aussi de flexion, de rigidité et de résistivité électrique ont été déterminées. Toutes les caractéristiques obtenues sont isotropes. Les résultats sont reportés dans le tableau ci-dessous :

| Matrice | Coefficient de dilatation entre 30 et 250°C | Conductivité Thermique | Masse Volumique | Module d'Young | Résistance en flexion | Résistivité électrique |
|---|---|---|---|---|---|---|
| | $10^{-6}.K^{-1}$ | $W.m^{-1}.K^{-1}$ | $kg.m^{-3}$ | GPa | MPa | Microhm-cm |
| AA1070 | 6.0 | 133 | 2200 | 20 | 58 | 125 |
| A357 | 7.4 | 142 | 2200 | 23 | 128 | 150 |
| AG5 | 7.9 | 124 | 2200 | . | . | . |
| AN5 | 5.3 | 124 | 2200 | . | . | . |
| RZ5 | 6.5 | 128 | 1700 | . | . | . |

Les différentes compositions d'alliages à base d'aluminium et de magnésium aboutissent à des compromis de propriétés différents. On remarque en particulier que l'on est capable d'obtenir des coefficients de dilatation très proches de ceux de l'alumine, de l'arseniure de gallium, tout en conservant une conductivité thermique très élevée.

EXEMPLE 4 :

on a réalisé des matériaux composites comprenant différents types de graphites polygranulaires de différentes densités (références S2512 - S2457 - S2545 du Carbone Lorraine) et un aluminium de pureté supérieure à 99,7%. La fraction volumique de graphite dans ces composites est comprise entre 50% et 90%.

Après infiltration et démoulage, on a obtenu des composites dont les propriétés de dilatation, de conductivité thermique, de masse volumique et parfois aussi de flexion, de rigidité et de résistivité électrique ont été déterminées. Toutes les caractéristiques obtenues sont isotropes. Les résultats sont rapportés dans le tableau ci-dessous :

| Fraction volumique de graphite | Référence du graphite | Coefficient de dilatation entre 30et250°C | Conductivité thermique | Masse Volumique | Module d'Young | Résistance en flexion | Résistivité électrique |
|---|---|---|---|---|---|---|---|
| % | | p.p.m/K | W/m/K | $kg/m^{-3}$ | GPa | MPa | Microhm-cm |
| 82 | S2512 | 4 | 113 | 2200 | 18 | 72 | – |
| 69 | S2457 | 6.0 | 133 | 2200 | 20 | 58 | 125 |
| 59 | S2545 | 10.0 | 129 | 2300 | 25 | 32 | 25 |

Les différentes nuances de graphite aboutissent à des compromis de propriétés différents. On remarque en particulier qu'avec la nuance de graphite S2512 on obtient un coefficient de dilatation équivalent à celui du silicium et du nitrure d'aluminium par exemple.

Tous les matériaux composites ainsi que les structures composites obtenues à partir de ces matériaux décrits dans les exemples 1 à 4 présentent un coefficient de dilatation moyen entre 30°C et 250°C inférieur à 13p.p.m./K et supérieur à 2 p.p.m./K dans toutes les directions.

Ces caractéristiques sont rappelées dans le tableau I.

TABLEAU I

| MATERIAUX ET STRUCTURES ISOTROPES | |
| --- | --- |
| Composite | Coefficient de dilatation entre 30°C et 250°C(p.p.m./K) |
| SiC particules AA1050 | 10,5 |
| Coke graphité/A9 | 10 |
| Graphite polygranulaire/AG5 | 7,9 |
| Graphite polygranulaire/A357 | 7,4 |
| Graphite polygranulaire/RZ5 | 6,5 |
| Graphite polygranulaire/AA1070 | 6 |
| Graphite polygranulaire/AN5 | 5.3 |
| Graphite polygranulaire/AA1070 | 4 |

**Revendications**

1. Matériau pour composants électroniques passifs ayant un coefficient de dilatation inférieur à 13 p.p.m./K, une densité inférieure à 3100 kg/m$^3$ dans lequel la structure est isotrope et qui est formé d'une part par un métal appartenant au groupe constitué par l'aluminium et ses alliages, le magnésium et ses alliages et d'autre part, par une céramique appartenant au groupe constitué par des particules de carbure de silicium vert, du graphite polygranulaire, ladite céramique étant utilisée en proportion volumique comprise entre 50 et 90%.

2. Matériau selon la revendication 1 ayant un coefficient de dilatation compris entre 7 et 13 p.p.m./K, une conductivité thermique supérieure à 150W/m/K, un module d'Young supérieur à 120 GPa dans lequel les particules de carbure de silicium vert sont utilisées en proportion volumique comprise entre 50 et 75%.

3. Matériau selon la revendication 1 ayant un coefficient de dilatation compris entre 4 et 10 p.p.m./K, une densité inférieure à 2300 kg/m$^3$, une conductivité thermique supérieure à 100 W/m/K, un module d'Young inférieur à 50 GPa dans lequel le graphite polygranulaire est utilisé en proportion volumique comprise entre 65 et 85%.

4. Matériau selon la revendication 1 dans lequel le métal appartient au groupe constitué par les alliages d'aluminium A356 et A357.

FIG.1

FIG .2

FIG.3

FIG.4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | US-A-4 569 692 (OLIN CORP.) <br> * revendications 1-4,12,15,16 * | 1 | H01L23/373 |
| A | | 2,3 | |
| | --- | | |
| Y | US-A-4 649 990 (HITACHI) <br> * colonne 5, ligne 29 - colonne 6, ligne 3 * | 1 | |
| A | | 2,3 | |
| | --- | | |
| A | CH-A-656 022 (BATTELLE) <br> * revendications 1,2,5 * <br> --- | 1-3 | |
| A | EP-A-0 064 264 (HITACHI) <br> * page 19, ligne 20 - ligne 25; revendication 1 * <br> --- | 1-3 | |
| A | US-A-4 352 120 (HITACHI) <br> * colonne 2, ligne 15 - ligne 56 * <br> --- | 1-3 | |
| A | GB-A-2 206 451 (GLASS-WELLS) <br> * revendications 1,3 * <br> --- | 1 | |
| A | 34TH ELECTRONIC COMPONENTS CONFERENCE <br> 14 Mai 1984, NEW ORLEANS, US <br> pages 388 - 393; <br> M. KOHARA ET AL.: 'Thermal-stress-free package <br> for flip-chip devices' <br> * tableau 1 * <br><br> ----- | 1-3 | **DOMAINES TECHNIQUES RECHERCHES (Int. Cl.5 )** <br><br> H01L |

Le présent rapport a été établi pour toutes les revendications

| Lieu de la recherche | Date d'achèvement de la recherche | Examinateur |
|---|---|---|
| LA HAYE | 11 NOVEMBRE 1991 | DE RAEVE R.A.L. |

EPO FORM 1503 03.82 (P0402)